(19) Europäisches Patentamt

European Patent Office

Office européen des brevets

(11) **EP 0 935 340 A2**

(12) **EUROPÄISCHE PATENTANMELDUNG**

(43) Veröffentlichungstag:
**11.08.1999 Patentblatt 1999/32**

(51) Int. Cl.$^6$: **H03G 3/00**, H03G 3/20

(21) Anmeldenummer: **99102124.7**

(22) Anmeldetag: **03.02.1999**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **07.02.1998 DE 19804922**

(71) Anmelder:
**GRUNDIG Aktiengesellschaft
90762 Fürth (DE)**

(72) Erfinder:
• **Carl, Holger
c/o Grundig AG
90762 Fürth (DE)**
• **Pablitschko, Thomas
c/o Grundig AG
90762 Fürth (DE)**

(54) **Verfahren und Vorrichtung zur Regelung der Verstärkung in einem Signalverarbeitungssystem**

(57) Die Erfindung betrifft ein Verfahren und eine Vorrichtung zur Regelung der Verstärkung in einem Signalverarbeitungssystem. Aus einem in digitaler Form vorliegenden Signal werden Blöcke mit einer vorgegebenen Anzahl von Signalabtastwerten gebildet. Für jeden dieser Blöcke erfolgt eine Ermittlung der Signalleistung. Die ermittelte Signalleistung wird zu einer rekursiven Ermittlung eines Leistungsschätzwertes verwendet. Dieser wiederum wird Schwellenwertvergleichen zugeführt. Überschreitet der ermittelte Leistungsschätzwert vorgegebene Schwellenwerte, dann erfolgt eine Verstärkungsänderung.

FIGUR 1

EP 0 935 340 A2

**Beschreibung**

Die Erfindung betrifft ein Verfahren und eine Vorrichtung zur Regelung der Verstärkung in einem Signalverarbeitungssystem.

Aus dem Fachbuch von Limann/Pelka: "Fernsehtechnik ohne Ballast", 14. Auflage, Franzis-Verlag GmbH, München, 1983, Seiten 196 bis 199, sind bereits Vorrichtungen zur automatischen Verstärkungs- und Kontrastregelung in Fernsehempfängern bekannt. Die automatische Verstärkungsregelung (AGC) dient zum Ausgleichen verschieden hoher Antennenspannungen, und sie soll der Bildröhre eine möglichst gleichbleibende Videospannung anbieten, da hiervon der richtige Kontrast abhängt. Weiterhin soll die automatische Verstärkungsregelung Übersteuerungen im Bild-ZF-Teil des Fernsehempfängers vermeiden. Zu dieser bekannten automatischen Verstärkungsregelung wird im Video-Demodulator eine Regelspannung gewonnen und zu einer Regelung der Verstärkung auf einen im Empfangsteil des Fernsehempfängers angeordneten regelbaren Verstärker zurückgeführt. Gegebenenfalls kann das genannte Regelsignal zusätzlich auch einem im ZF-Teil des Fernsehempfängers vorgesehenen Verstärker zu dessen Verstärkungseinstellung zugeführt werden.

Aus der DE-A1-42 41 028 ist ein Verfahren zur Aufbereitung eines Reglerstellsignal sowie eine zugehörige Anordnung und Verwendung bekannt. Das bekannte Verfahren beruht darauf, daß zur Konstanthaltung von Hochfrequenzsignalen, beispielsweise n-PSK-Signalen in der Zwischenfrequenzebene, AGC-Verstärker eingesetzt werden, wobei bei stark verrauschten Signalen die Regelung durch Rauschanteile ungünstig beeinflußt wird. Zur Kompensation dieser Rauschanteile wird bei der Aufbereitung des Stellsignals das störbehaftete Hochfrequenzsignal an einer Stelle, an der der Rauschleistungsanteil größer ist als der Nutzsignalanteil, schmalbandig gefiltert. Das so gewonnene Korrektursignal wird dann, gegebenenfalls nach einer entsprechenden Gewichtung, vom Stellsignal subtrahiert.

Weiterhin ist aus der DE-A1-44 07 032 eine Vorrichtung zur Sprachsignalverarbeitung bekannt. Diese Vorrichtung weist eine Verstärkungsregelung (AGC) zur Verstärkung eines Sprachsignals und eine Steuerschaltung auf. Unter Verwendung der Steuerschaltung werden Sprachpausen im Sprachsignal detektiert und die Verstärkung des Sprachsignals derart beeinflußt, daß sie innerhalb der Sprachpausen nicht über eine jeweils vorgegebene Verstärkung ansteigt. Dies führt dazu, daß keine störende Verstärkung des Hintergrundrauschens auftritt.

Ausgehend von diesem Stand der Technik liegt der Erfindung die Aufgabe zugrunde, ein neues und vorteilhaftes Verfahren zur Regelung der Verstärkung in einem Signalverarbeitungssystem anzugeben.

Diese Aufgabe wird durch ein Verfahren mit den im Anspruch 1 angegebenen Merkmalen gelöst. Vorteilhafte Ausgestaltungen und Weiterbildungen der Erfindung ergeben sich aus den abhängigen Ansprüchen 2 bis 12. Die Ansprüche 13 bis 25 betreffen eine Vorrichtung zur Regelung der Verstärkung in einem Signalverarbeitungssystem.

Die Vorteile der Erfindung bestehen insbesondere darin, daß aufgrund der Ermittlung des Verstärkungsregelsignals durch Auswertung des in digitaler Form vorliegenden Signals die Reaktionsgeschwindigkeit und das Verhalten der Verstärkungsregelung in einfacher Weise an das jeweils vorliegende Signalverarbeitungssystem angepaßt werden kann. Durch die Ermittlung zweier verschiedener Leistungsschätzwerte, wie sie im Anspruch 2 angegeben sind, wird in vorteilhafter Weise die Möglichkeit geschaffen, für ein Hochregeln der Verstärkung eine andere Regelcharakteristik zu verwenden als für ein Herunterregeln der Verstärkung.

In den Ansprüchen 3 und 4 ist angegeben, wie die Leistung eines Blockes bzw. die einem Herunterregeln und Hochregeln der Verstärkung zugeordneten Leistungsschätzwerte ermittelt werden können.

Die Ansprüche 5 und 6 geben an, daß die Parameter, die die Größe des Einflusses der Leistung vorhergehender Blöcke angeben, für das Hochregeln der Verstärkung anders gewählt werden als für das Herunterregeln. Damit wird die Möglichkeit dafür geschaffen, daß bei einem Vorliegen von Übersteuerungen die Verstärkung sehr schnell heruntergeregelt wird, während Untersteuerungen nur langsam ausgeregelt werden.

Dieser Effekt wird noch unterstützt, wenn - wie im Anspruch 7 angegeben - für das Herunterregeln größere Verstärkungsschritte verwendet werden als für das Hochregeln.

Durch die im Anspruch 8 angegebenen Merkmale wird erreicht, daß das Hochregeln der Verstärkung weiter verlangsamt ist.

Gemäß der Merkmale des Anspruchs 9 wird der einem Hochregeln der Verstärkung zugeordnete Leistungsschätzwert nicht aktualisiert, wenn der einem Herunterregeln der Verstärkung zugeordnete Leistungsschätzwert einen zugehörigen oberen Schwellenwert überschreitet. Tritt beispielsweise ein kurzes lautes Störgeräusch auf, dann wird die Verstärkung schnell heruntergeregelt. Da der einem Hochregeln der Verstärkung zugeordnete Leistungsschätzwert nicht aktualisiert wird, kann das erneute Hochregeln der Verstärkung relativ schnell erfolgen.

Weitere vorteilhafte Eigenschaften der Erfindung ergeben sich aus der Erläuterung eines Ausführungsbeispiels anhand der Zeichnungen.

Es zeigt:

FIG 1     eine Vorrichtung zur Regelung der Verstärkung in einem Signalverarbeitungssystem und

FIG 2 ein Flußdiagramm zur Veranschaulichung der Wirkungsweise der Vorrichtung gemäß Figur 1.

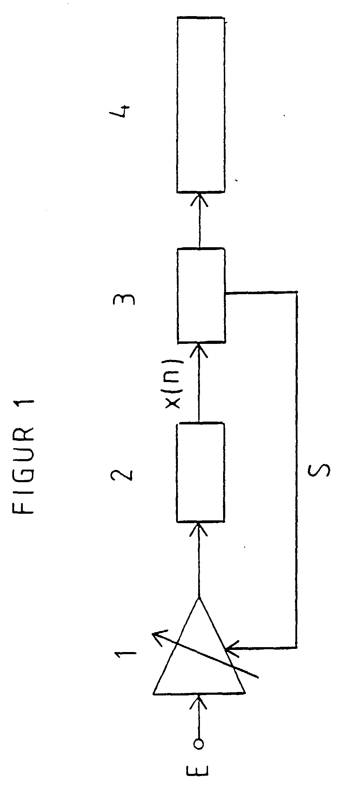

Die Figur 1 zeigt eine Vorrichtung zur Regelung der Verstärkung in einem Signalverarbeitungssystem. Dieses Signalverarbeitungssystem ist vorzugsweise ein digitales Sprachverarbeitungssystem. Es kann sich beispielsweise jedoch auch um ein anderes digitales Audiosystem oder um ein digitales Videosystem handeln.

Am Eingang E der gezeigten Vorrichtung liegt ein analoges Sprachsignal an. Dieses wird in einem regelbaren Analogverstärker 1 verstärkt und einem Analog/Digital-Wandler 2 zugeführt. In diesem wird das verstärkte analoge Sprachsignal in ein digitales Sprachsignal x(n) umgesetzt. Vom Ausgang des Analog/Digital-Wandlers 2 gelangt das digitale Sprachsignal x(n) an eine Mikrocomputereinheit 3, die ausgangsseitig ein Verstärkungsregelsignal S für den Verstärker 1 zur Verfügung stellt. Weiterhin ist ein digitaler Ausgang der Mikrocomputereinheit 3 mit einer digitalen Signalverarbeitungsschaltung 4 verbunden, in der eine weitere, für das Verständnis der vorliegenden Erfindung nicht wesentliche Verarbeitung des digitalen Sprachsignals erfolgt.

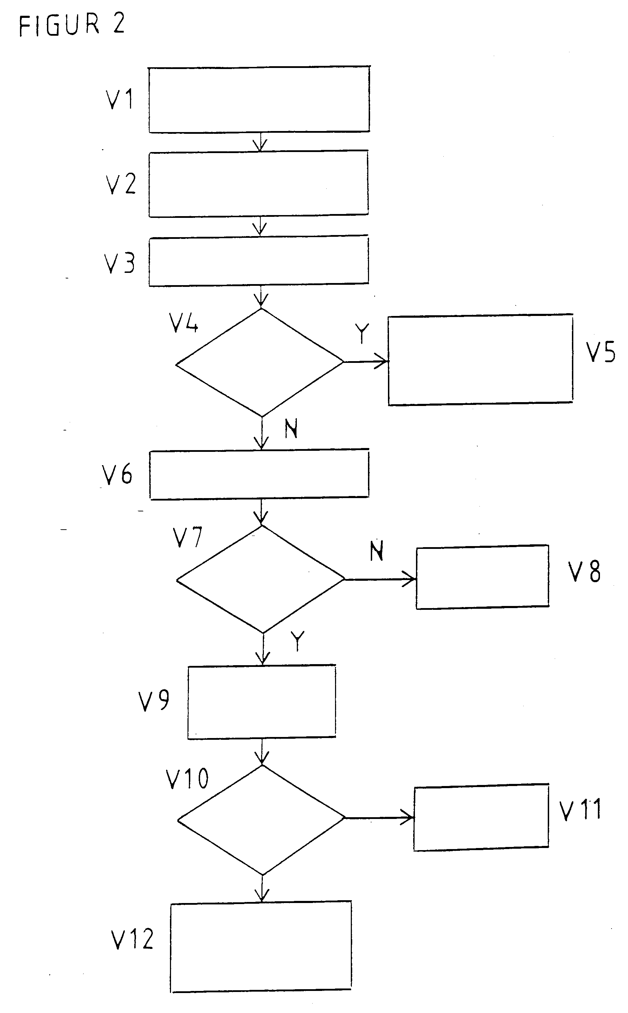

Die Mikrocomputereinheit 3 ist derart programmiert, daß sie das ihr zugeführte digitale Sprachsignal x(n) zur Ermittlung des Verstärkungsregelsignals nach einem Verfahren verarbeitet, wie es durch das in der Figur 2 angegebene Flußdiagramm beschrieben ist.

Zunächst werden in einem ersten Verfahrensschritt V1 aus dem in digitaler Form vorliegenden Signal x(n) Blöcke gebildet, die jeweils eine Anzahl N von Abtastwerten aufweisen. In einem zweiten Verfahrensschritt V2 erfolgt eine Berechnung der Leistung eines aktuellen Blockes beispielsweise nach der Beziehung

$$C(i) = \frac{1}{N} \sum_{k=0}^{N-1} x(iN + k)^2. \qquad (1)$$

Im nächsten Schritt V3 wird unter Verwendung der ermittelten Leistung C(i) des aktuellen Blockes der Leistungsschätzwert $C_{down}(i)$ aktualisiert, der die Grundlage für ein Herunterregeln der Verstärkung bildet. Diese Aktualisierung geschieht beispielsweise nach der Beziehung

$$C_{down}(i) = a_{down} \, C_{down}(i-1) + (1 - a_{down}) \cdot C(i). \qquad (2)$$

Überschreitet der ermittelte Wert für $C_{down}(i)$ einen vorgegebenen oberen Grenzwert MAX, was im vierten Verfahrensschritt V4 überprüft wird, dann wird im fünften Verfahrensschritt V5 ein Wartezähler zurückgesetzt, ein Signal S erzeugt, aufgrund dessen die Verstärkung des Verstärkers 1 beispielsweise um D dB heruntergeregelt wird und die Berechnung eines Verstärkungsregelsignals für den aktuellen Block beendet.

Ergibt die Überprüfung im vierten Verfahrensschritt V4 hingegen, daß der ermittelte Wert für $C_{down}(i)$ den vorgegebenen Grenzwert MAX nicht überschreitet, dann erfolgt in einem Verfahrensschritt V6 unter Verwendung der ermittelten Leistung C(i) des aktuellen Bocks eine Aktualisierung des Leistungsschätzwertes $C_{up}(i)$, der die Grundlage für ein Hochregeln der Verstärkung bildet. Diese geschieht zum Beispiel nach der Beziehung

$$C_{up}(i) = a_{up} \, C_{up}(i-1) + (1 - a_{up}) \cdot C(i). \qquad (3)$$

Unterscheidet der ermittelte Wert für $C_{up}(i)$ einen vorgegebenen unteren Grenzwert MIN nicht, was im siebten Verfahrensschritt V7 überprüft wird, dann wird im achten Verfahrensschritt V8 der Wartezähler zurückgesetzt und die Berechnung eines Verstärkungsregelsignals für den aktuellen Block beendet.

Ergibt die Überprüfung im siebten Verfahrensschritt V7 hingegen, daß der ermittelte Wert für $C_{up}(i)$ den vorgegebenen unteren Grenzwert MIN überschreitet, dann erfolgt in einem Verfahrensschritt V9 eine Erhöhung des Wartezählers um 1.

Danach erfolgt in einem Verfahrensschritt V10 eine Abfrage, ob der Wartezähler einen vorgegebenen Zählwert M erreicht hat oder nicht. Ist das nicht der Fall, dann wird in einem Verfahrensschritt V11 die Berechnung eines Verstärkungsregelsignals für den aktuellen Block beendet. Hat der Wartezähler hingegen den Zählwert M erreicht, was dann der Fall ist, wenn bei einer Überprüfung von M aufeinanderfolgenden Blöcken ein Unterschreiten des unteren Grenzwertes MIN festgestellt wurde, dann wird in einem Verfahrensschritt V12 ein Signal S erzeugt, aufgrund dessen die Verstärkung des Verstärkers 1 beispielsweise um U dB hochgeregelt wird und die Berechnung des Verstärkungsregelsignals für den aktuellen Block beendet.

Die in den obigen Beziehungen (2) und (3) angegebenen Faktoren bzw. Parameter $a_{down}$ und $a_{up}$ geben Auskunft über die Größe des Einflusses der Leistung vorhergehender Blöcke in die Berechnung des jeweiligen Leistungsschätzwertes. Vorzugsweise wird der in die Berechnung des Leistungsschätzwertes $C_{down}(i)$ eingehende Parameter $a_{down}$ größer gewählt als der in die Berechnung des Leistungsschätzwertes $C_{up}(i)$ eingehende Parameter $a_{up}$.

Dies hat, bei geeigneter Parameterwahl, zur Folge, daß das Regelsystem auf Übersteuerungen sehr schnell reagiert, während zu niedrige Signalpegel nur langsam, das heißt vorsichtig, hochgeregelt werden.

Weiterhin werden beim beschriebenen Verfahren in vorteilhafter Weise die Verstärkungsregelsignale von der Mikrocomputereinheit 3 derart erzeugt, daß zu einem Herunterregeln der Verstärkung größere Verstärkungsschritte verwendet werden als für ein Hochregeln der Verstärkung, d. h.

D > U.

Dies beschleunigt die Reaktion des Systems beim Vorliegen von Übersteuerungen weiter.

Die Leistungsschätzwerte $C_{up}$ und $C_{down}$ werden vor dem Beginn der vorstehend beschriebenen Berechnungen auf sinnvolle Vorgabewerte gesetzt, beispielsweise gilt:

$$C_{down}(0)=C_{up}(0)=MAX/2.$$

Durch die beschriebene rekursive Aktualisierung der Leistungsschätzwerte $C_{down}(i)$ und $C_{up}(i)$ unter Verwendung der Parameter $a_{down}$ und $a_{up}$ kann der Einfluß von vorangegangenen Leistungswerten im Verhältnis zur aktuellen Blockleistung in Abhängigkeit vom jeweiligen Anwendungsfall beliebig abgestimmt werden. Zu diesem Zweck können auch die weiteren Verfahrensparameter N, MAX, D, MIN, M und U verändert werden, um die Reaktionsgeschwindigkeit und das Verhalten der automatischen Verstärkungsregelung optimal an die jeweils vorliegenden Bedürfnisse anzupassen.

**Patentansprüche**

1.  Verfahren zur Regelung der Verstärkung in einem Signalverarbeitungssystem,
    **dadurch gekennzeichnet, daß**

    - aus dem in digitaler Form vorliegenden Signal Blöcke mit einer vorgegebenen Anzahl von Signalabtastwerten gebildet werden,
    - für jeden Block die Signalleistung ermittelt wird,
    - unter Verwendung der Signalleistung eine rekursive Ermittlung eines Leistungsschätzwertes erfolgt,
    - der ermittelte Leistungsschätzwert einem Schwellenwertvergleich zugeführt wird,
    - eine Verstärkungsänderung dann erfolgt, wenn der ermittelte Leitstungsschätzwert vorgegebene Schwellenwerte über- bzw. unterschreitet und
    - zwei Leistungsschätzwerte ermittelt werden, von denen einer einem Hochregeln der Verstärkung und der andere einem Herunterregeln der Verstärkung zugeordnet ist.

2.  Verfahren nach Anspruch 1,
    **dadurch gekennzeichnet, daß**

    die Leistung eines Blockes nach der Beziehung

    $$C(i) = \frac{1}{N} \sum_{k=0}^{N-1} x(iN + k)^2$$

ermittelt wird, wobei i die Nummer des Blockes und N die Anzahl der Abtastwerte eines Blockes sind und

der einem Herunterregeln der Verstärkung zugeordnete Leistungsschätzwert nach der Beziehung

$$C_{down}(i)=a_{down}\,C_{down}(i\text{-}1)+(1\text{-}\,a_{down})\cdot C(i)$$

und der einem Hochregeln der Verstärkung zugeordnete Leistungsschätzwert nach der Beziehung

$$C_{up}(i)=a_{up}\,C_{up}(i\text{-}1)+(1\text{-}\,a_{up})\cdot C(i)$$

ermittelt wird, wobei $a_{down}$ und $a_{up}$ Parameter sind, die die Größe des Einflusses der Leistung vorhergehender Blöcke angeben.

3.  Verfahren nach Anspruch 2,
    **dadurch gekennzeichnet, daß**

    die Parameter $a_{down}$ und $a_{up}$ unterschiedliche Zahlenwerte aufweisen und der Zahlenwert für $a_{up}$ kleiner ist als der Zahlenwert für $a_{down}$.

4.  Verfahren nach einem der vorhergehenden Ansprüche,
    **dadurch gekennzeichnet, daß**

    für ein Herunterregeln der Verstärkung größere Verstärkungsschritte verwendet werden als für ein Hochregeln der Verstärkung.

5.  Verfahren nach einem der vorhergehenden Ansprüche,
    **dadurch gekennzeichnet, daß**

    ein Hochregeln der Verstärkung erst dann erfolgt, wenn der einem Hochregeln der Verstärkung zugeordnete Leistungsschätzwert in mehreren aufeinanderfolgenden Blöcken einen unteren Schwellenwert unterschritten hat.

6.  Verfahren nach einem der vorhergehenden Ansprüche,
    **dadurch gekennzeichnet, daß**

    der einem Hochregeln der Verstärkung zugeordnete Leistungsschätzwert nicht aktualisiert wird, wenn der einem Herunterregeln der Verstärkung zugeordnete Leistungsschätzwert einen zugehörigen oberen Schwellenwert überschreitet.

7.  Verfahren nach einem der vorhergehenden Ansprüche,
    **dadurch gekennzeichnet, daß**

das Signalverarbeitungssystem ein Audiosignalverarbeitungssystem ist und das Audiosignalverarbeitungssystem ein Sprachsignalverarbeitungssystem ist.

8. Verfahren nach einem der Ansprüche 1 bis 6,
**dadurch gekennzeichnet, daß**

das Signalverarbeitungssystem ein Videoverarbeitungssystem ist.

9. Vorrichtung zur Regelung der Verstärkung in einem Signalverarbeitungssystem,
**dadurch gekennzeichnet, daß**

sie eine Mikrocomputereinheit (3) aufweist, welcher eingangsseitig ein digitales Signal zugeführt wird und welche ausgangsseitig ein Verstärkungsregelsignal (S) für einen im Signalweg angeordneten Verstärker (1) zur Verfügung stellt, wobei die Mikrocomputereinheit (3) derart programmiert ist, daß

- sie aus dem digitalen Signal Blöcke mit einer vorgegebenen Anzahl von Signalabtastwerten bildet,

- für jeden Block die Signalleistung ermittelt,

- unter Verwendung der Signalleistung eine rekursive Ermittlung eines Leistungsschätzwertes durchführt,

- den ermittelten Leistungsschätzwert einem Schwellenwertvergleich zuführt, und

- ein zur einer Verstärkungsänderung vorgesehenes Ausgangssignal dann zur Verfügung stellt, wenn der ermittelte Leistungsschätzwert vorgegebene Schwellenwerte über- bzw. unterschreitet.

10. Vorrichtung nach Anspruch 9,
**dadurch gekennzeichnet, daß**

die Mikrocomputereinheit derart programmiert ist, daß sie zwei Leistungsschätzwerte ermittelt, von denen einer einem Hochregeln der Verstärkung und der andere einem Herunterregeln der Verstärkung zugeordnet ist.

11. Vorrichtung nach Anspruch 9 oder 10,
**dadurch gekennzeichnet, daß**

die Mikrocomputereinheit die Leistung eines Blockes nach der Beziehung

$$C(i) = \frac{1}{N} \sum_{k=0}^{N-1} x(iN + k)^2$$

ermittelt.

12. Vorrichtung nach Anspruch 9 oder 10,
**dadurch gekennzeichnet, daß**

die Mikrocomputereinheit den einem Herunterregeln der Verstärkung zugeordneten Leistungsschätzwert nach der Beziehung

$$C_{down}(i) = a_{down}\, C_{down}(i-1) + (1 - a_{down}) \cdot C(i)$$

Ermittelt, die Parameter $\alpha_{up}$ und $\alpha_{down}$ unterschiedliche Zahlenwerte aufweisen und der Zahlenwert für $\alpha_{up}$ kleiner ist als der Zahlenwert $\alpha_{down}$.

13. Vorrichtung nach einem der Ansprüche 9 bis 12,
**dadurch gekennzeichnet, daß**

das von der Mikrocomputereinheit erzeugte Verstärkungsregelsignal für ein Herunterregeln der Verstärkung größere Verstärkungsschritte aufweist als für ein Hochregeln der Verstärkung.

14. Vorrichtung nach einem der Ansprüche 9 bis 13,
**dadurch gekennzeichnet, daß**

die Mikrocomputereinheit derart programmiert ist, daß sie ein zum Hochregeln der Verstärkung vorgesehenes Verstärkungsregelsignal erst dann erzeugt, wenn der einem Hochregeln der Verstärkung zugeordnete Leistungsschätzwert in mehreren aufeinanderfolgenden Blökken einen unteren Schwellenwert überschritten hat.

15. Vorrichtung nach einem der Ansprüche 9 bis 14,
**dadurch gekennzeichnet, daß**

die Mikrocomputereinheit derart programmiert ist, daß der einem Hochregeln der Verstärkung zugeordnete Leistungsschätzwert nicht aktualisiert wird, wenn der einem Herunterregeln der Verstärkung zugeordnete Leistungsschätzwert einen zugehörigen oberen Schwellenwert überschreitet.

16. Vorrichtung nach einem der Ansprüche 9 bis 15,
**dadurch gekennzeichnet, daß**

sie Bestandteil eines Audiosignalverarbeitungsgerätes ist und das Audiosignalverarbeitungsgerät ein Sprachsignalverarbeitungsgerät ist oder Bestandteil eines Videosignalverarbeitungsgerätes ist.

17. Vorrichtung nach einem der Ansprüche 9 bis 16,
**dadurch gekennzeichnet, daß**

das Signalverarbeitungssystem einen regelbaren Analogverstärker (1) und einen mit dessen
Ausgang verbundenen Analog/Digital-Wandler
(2) aufweist, daß der Analog/Digital-Wandler
ausgangsseitig mit der Mikrocomputereinheit
(3) verbunden ist und daß das von der Mikrocomputereinheit zur Verfügung gestellte Verstärkungsregelsignal einem Regeleingang des
regelbaren Analogverstäkers (1) zugeführt ist.

FIGUR 1

EP 0 935 340 A2

FIGUR 2